Europäisches Patentamt

European Patent Office

Office européen des brevets

(19)

(11) Numéro de publication : **0 509 900 A1**

# (12) DEMANDE DE BREVET EUROPEEN

(21) Numéro de dépôt : **92401038.2**

(22) Date de dépôt : **14.04.92**

(51) Int. Cl.$^5$ : **H01P 5/18,** G01R 21/01

(30) Priorité : **19.04.91 FR 9104860**

(43) Date de publication de la demande :
**21.10.92 Bulletin 92/43**

(84) Etats contractants désignés :
**CH DE FR GB IT LI**

(71) Demandeur : **THOMSON TUBES
ELECTRONIQUES
38, rue Vauthier
F-92100 Boulogne-Billancourt (FR)**

(72) Inventeur : **Mourier, Georges
THOMSON-CSF, SCPI, Cédex 67
F-92045 Paris la Défense (FR)**

(74) Mandataire : **Guérin, Michel et al
THOMSON-CSF SCPI
F-92045 PARIS LA DEFENSE CEDEX 67 (FR)**

(54) **Coupleur directionnel sur coude à miroir pour ondes hyperfréquences.**

(57)   L'invention concerne un coupleur direction-nel sur coude à miroir pour ligne de transmis-sion hyperfréquence dimensionnée pour véhiculer de très hautes puissances. Le cou-pleur consiste en un guide principal (A) avec un coude à miroir (6) et au moins un guide secon-daire (B). Le guide secondaire (B) est accolé par l'une de ses parois sur la surface externe du miroir, et l'intérieur du guide secondaire (B) est couplé à l'intérieur du coude à miroir par des trous (5) de couplage.

FIG. 4

EP 0 509 900 A1

La présente invention a pour objet un coude à miroir avec coupleur directionnel pour des lignes de transmission d'ondes hyperfréquences de très grande puissance. Des lignes de transmission de puissance hyperfréquence trouvent leurs applications notamment dans les domaines de la physique des plasmas, ou encore de la fusion thermonucléaire, où il est souvent nécessaire de véhiculer de très grandes puissances d'énergie électromagnétique, de longueur d'onde millimétrique ou infra-millimétrique, sur des distances plus ou moins importantes pouvant atteindre parfois plusieurs dizaines de mètres, entre les générateurs de puissance hyperfréquence et l'utilisation, dans un tokamak par exemple.

Pour minimiser les pertes de transmission, il est connu d'utiliser des guides d'ondes surdimensionnés comme ligne de transmission. Des éléments spécifiques sont utilisés pour dévier la direction de propagation de l'énergie électromagnétique à l'intérieur de la ligne de transmission (tels les coudes), ou encore pour en changer le mode de propagation (convertisseurs de modes, guides surdimensionnés corrugués... ).

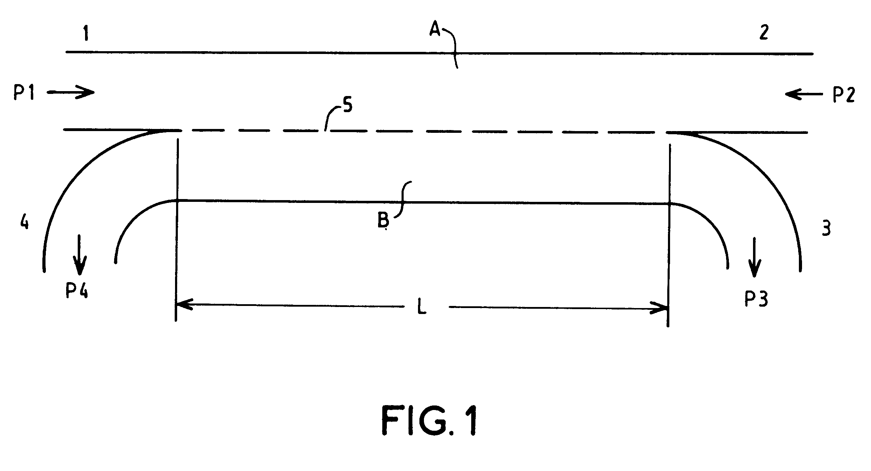

Dans des lignes de transmission de puissance plus faible, il est connu d'utiliser un coupleur directionnel (figure 1) pour prélever une partie de l'énergie transmise, ou, dans le sens inverse, pour prélever une partie de l'énergie réfléchie. Un étalonnage du coupleur permet, en mesurant l'énergie prélevée, de calculer la puissance véhiculée par la ligne de transmission elle -même.

Un coupleur directionnel classique est constitué par un guide d'ondes accolé au guide d'ondes principal de la ligne de transmission, couplé à ce dernier par une série de trous de couplage répartis sur une longueur L (figure 1). Le coupleur classique de la figure 1 peut être caractérisé par deux paramètres :

1) le facteur de couplage $C = P_3/P_1$ et

2) la directivité $D = P_3/p_4$, mesurée à $P_2 = 0$ (puissance réfléchie nulle ).

Alors que la réalisation d'un coupleur classique peut être aisée dans le cas des guides principaux rectangulaires fonctionnant dans des modes de propagation fondamentaux ou de nombre propre peu élevé ; il n'en est pas de même pour des guides spéciaux employés pour véhiculer les très hautes puissances requises pour la fusion thermonucléaire. En effet, de telles applications font souvent l'utilisation de guides surdimensionnés, de section circulaire, lisses ou corrugués, éventuellement entourés d'une enceinte à vide ou d'un revêtement permettant le refroidissement des parois du guide à l'aide d'un liquide ou d'un gaz en circulation pour évacuer la chaleur générée dans les parois conductrices du guide d'ondes par des pertes hyperfréquence.

La structure d'une ligne de transmission de puissance hyperfréquence composée de tels guides est complexe et se prête difficilement à l'adjonction d'un guide secondaire pour former un coupleur classique tel que montré schématiquement sur la figure 1.

C'est un objet de la présente invention de remédier à cette difficulté en proposant un coupleur d'une conception nouvelle qui ne présente pas ces inconvénients.

La ligne de transmission de très hautes puissances comporte presque toujours des coudes, généralement proches du générateur ou de l'utilisateur, ceci pour des raisons pratiques de premier ordre. Par exemple, le générateur est souvent de type gyrotron, un tube électronique qui fonctionne en général disposé verticalement, et dont l'énergie sort à la verticale. Pour amener son énergie à l'utilisateur éloigné de quelques dizaines de mètres à l'horizontal, au moins un coude sera nécessaire. De la même manière près de l'utilisateur (un tokamak par exemple) de nombreuses lignes de transmission hyperfréquence convergent des différentes sources, et doivent être couplées à l'utilisateur, disposées parmi d'autres dispositifs ( sondes, sources de gaz, alimentations diverses, électroaimants, refroidissement, lasers, ... ) qui peuvent présenter des interférences mécaniques. Ces interférences mécaniques seront alors contournées à l'aide des coudes placés dans la ligne de transmission près de l'utilisateur.

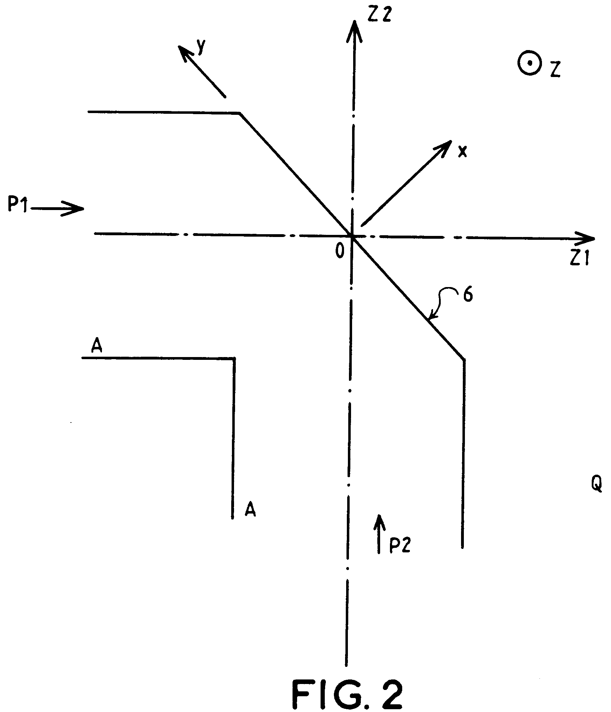

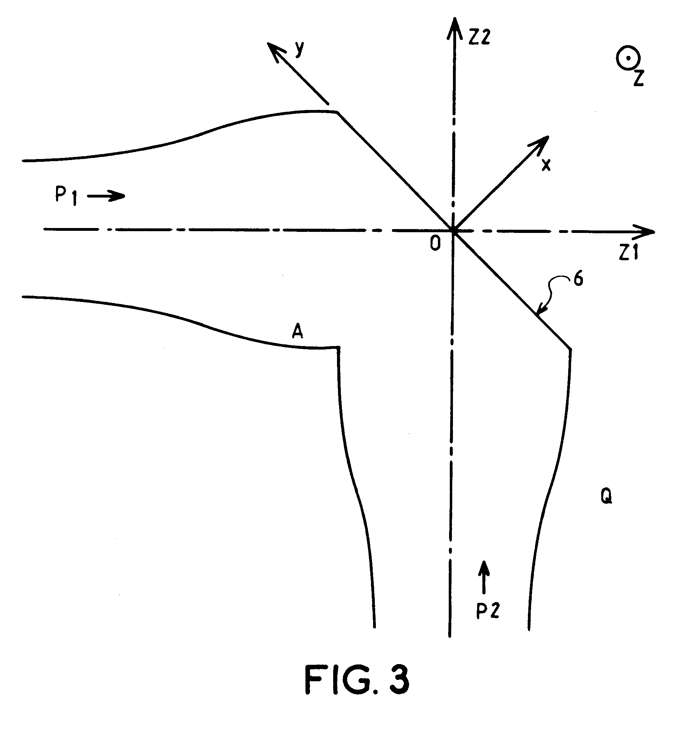

Pour des grandes puissances et des hautes fréquences (et donc des longueurs d'onde courtes), des coudes à miroir sont fréquemment utilisés, avec une structure dont deux exemples connus de l'art antérieur sont montrés schématiquement sur les figures 2 et 3.

Pour pallier aux difficultés de réalisation de coupleurs de mesures sur des lignes de transmission de hautes puissances et hautes fréquences rencontrées dans l'art antérieur, l'invention propose de réaliser un coupleur directionnel à partir d'un guide d'ondes principal comportant un coude à miroir apte à changer la direction de propagation d'une onde électromagnétique, d'une première direction incidente $Z_1$ à une deuxième direction sortante $Z_2$, $Z_1$ et $Z_2$ définissant un plan (Q) contenant $Z_1$ et $Z_2$, le miroir du coude à miroir étant disposé perpendiculaire audit plan (Q) du coude à miroir. Au moins un guide d'ondes secondaire est accolé et couplé au guide d'ondes principal au niveau du miroir par des trous de couplage.

Le guide secondaire aura quatre côtés, dont deux relativement plus larges se faisant face, et deux autres relativement moins larges se faisant face.

Selon une caractéristique de l'invention, le guide secondaire peut être accolé au miroir par l'un de ses grands côtés. Ce guide fonctionnera en mode $TE_{01}$ ou similaire.

Ou bien il peut être accolé au miroir par un de ses petits côtés. Ce guide fonctionnera en mode $TE_{10}$ ou similaire.

Selon une autre caractéristique de l'invention, lorsque deux guides secondaires sont accolés au miroir, l'un peut être accolé au miroir par un petit côté et l'autre par un grand côté.

Le miroir peut être plan ou courbe de façon à supprimer la divergence résultant de l'incidence d'une onde sphérique sur un miroir plan. Dans cette dernière configuration, le guide d'ondes secondaire sera donc légèrement courbé pour épouser la courbure du miroir.

Dans toutes les variantes de l'invention, la réalisation d'un coupleur directionnel pour une ligne de transmission hyperfréquence de fortes puissances à de très hautes fréquences est très largement simplifiée par rapport aux réalisations connues de l'art antérieur. De plus, l'orientation du coupleur directionnel peut servir pour échantillonner une polarisation précise à l'intérieur du guide principal. Finalement, selon la dernière caractéristique mentionnée, on peut facilement réaliser un coupleur à deux voies pour échantillonner deux polarisations orthogonales simultanément dans un dispositif particulièrement simple, donc facile à fabriquer et relativement moins cher.

Dans toutes les variantes de l'invention, l'encombrement et les risques d'interférences mécaniques avec les autres composants du système sont considérablement réduits.

D'autres caractéristiques et avantages du dispositif du coupleur selon l'invention ressortiront de la description détaillée faite ci-après, à l'aide des figures annexées dont :
- la figure 1, déjà mentionnée, montre schématiquement et en coupe axiale un coupleur directionnel multi-trous connu de l'art antérieur ;
- la figure 2 montre schématiquement et en coupe un coude classique à miroir, connu de l'art antérieur, pour changer la direction de propagation à l'intérieur de la ligne de transmission ;
- la figure 3 montre schématiquement et en coupe un autre coude à miroir connu de l'art antérieur, conçu pour minimiser les effets de la diffraction dans la région du miroir ;
- la figure 4 montre schématiquement et en coupe un dispositif selon l'invention, de coupleur directionnel couplé à un coude à miroir par des trous de couplage ;
- la figure 5 montre schématiquement et en coupe un détail d'un guide secondaire rectangulaire, accolé au miroir et couplé avec des trous à travers le miroir et le grand côté dudit guide secondaire ;
- la figure 6 montre schématiquement et en coupe un détail d'un guide secondaire rectangulaire, accolé au miroir, et couplé avec des trous à travers le miroir et le petit côté dudit guide secondaire ;
- la figure 7 montre schématiquement et en plan un dispositif selon l'invention, où deux guides secondaires sont accolés sur le miroir d'un coude à miroir, les deux guides étant orientés de façon à ce que l'un est accolé au miroir par une paroi relativement moins large du rectangle tandis que l'autre est accolé au miroir par une paroi relativement plus large du rectangle, permettant d'échantillonner les deux polarisations orthogonales simultanément.
- la figure 8 montre schématiquement un coupleur selon l'invention avec un miroir courbe.

Les figures représentent des exemples non limitatifs de réalisations, sur lesquelles les mêmes repères désignent les mêmes éléments sur les différentes figures. D'autres réalisations selon l'invention ou ses principales caractéristiques seront facilement imaginées par l'homme de l'art, à partir des principes illustrés par les exemples donnés ci-après.

La figure 1 montre schématiquement et en coupe axiale un coupleur directionnel multi-trous connu de l'art antérieur. Sur le dessin, on voit que le coupleur consiste de façon générale en deux guides d'ondes, un premier guide dit principal A ayant une première extrémité 1 pour l'entrée de puissance incidente $P_1$ provenant d'un générateur hyperfréquence (non montré) et une deuxième extrémité 2 dont la puissance de sortie est acheminée vers l'utilisation (non montrée) qui, dans le cas d'une adaptation imparfaite de cette dernière, reflète une puissance réfléchie $P_2$ vers le coupleur ; et un deuxième guide dit secondaire B ayant une première extrémité 3 pour le prélèvement d'une partie $P_3$ de la puissance incidente $P_1$ et une deuxième extrémité 4 pour le prélèvement d'une partie $P_4$ de la puissance réfléchie $P_2$. Le guide principal A et le guide secondaire B sont accolés sur une partie de leurs parois, selon la longueur et dans le sens de la propagation de l'énergie à l'intérieur des guides, et des trous de couplage 5 sont pratiqués à travers ces parois accolées sur une longueur L pour permettre le prélèvement d'une partie de l'énergie circulant à l'intérieur du guide principal A vers le guide secondaire B.

L'énergie ainsi prélevée vers le guide secondaire B est proportionnelle à l'énergie circulant à l'intérieur du guide principal A, dans un rapport qui dépend du nombre, de la taille, et de la disposition des trous de couplage 5. Par des mesures d'étalonnage, ce rapport peut être déterminé expérimentalement, et par la suite d'un tel étalonnage, le coupleur peut être utilisé pour connaître la puissance incidente $P_1$ et la puissance réfléchie $P_2$ à un grand degré de précision.

La réalisation d'un tel coupleur est relativement aisée dans le cas où le guide principal A et le guide secondaire B sont rectangulaires de section et rectilignes sur une longueur de plusieurs centimètres pour permettre la juxtaposition des parois des deux guides ; de tels coupleurs sont courants dans le commerce pour l'utilisation à des fréquences allant de quelques centaines de MHz à quelques centaines de GHz, pour des puissances $P_1$ allant de quelques mW à quelques dizaines, voire quelques centaines de kW.

Si le guide principal A est de section circulaire à paroi lisse, la réalisation n'est que légèrement compliquée à condition que le rayon de la section du guide A ne soit pas trop petit. Par contre, l'interprétation des mesures des puissances $P_3$ et $P_4$ circulant dans le guide secondaire B peut être compliquée par la possibilité de l'existence de plusieurs modes de propagation à l'intérieur du guide principal circulaire, car le coefficient de couplage n'est pas forcément le même pour tous ces modes.

Si le guide principal A est de section circulaire et corrugué selon sa longueur, la réalisation d'un coupleur classique devient très difficlle, sinon impossible.

Pour véhiculer de très grandes puissances (plusieurs MW) à de très hautes fréquences (de l'ordre de 100 GHz), le guide circulaire surdimensionné est utilisé de préférence, mais la réalisation de coupleurs classiques présentent les difficultés évoquées ci-dessus. Le coupleur selon l'invention a pour but de pallier à ces difficultés de réalisation et d'utilisation rencontrées dans l'art antérieur.

La figure 2 montre schématiquement et en coupe sur le plan Q un exemple simplifié de coude à miroir connu de l'art antérieur pour une ligne de transmission hyperfréquence, avec un système de coordonnées cartésiennes qui nous sera utile pour la description qui suivra. Dans l'exemple très simple d'un coude à miroir montré sur cette figure, le guide principal A est de section constante en amont et en aval d'un coude à 90° dont le changement de la direction de propagation est obtenu par un miroir plan 6 dont le centre géométrique est situé à l'origine 0 de notre système de coordonnées. Le guide principal est symétrique, à part dans la région du coude, autour d'un axe qui est indiqué en pointillé sur le dessin. Ainsi, l'origine 0 de notre système de coordonnées est à l'intersection de l'axe de la partie en amont, avec l'axe de la partie en aval du guide principal A.

Les axes cartésiens x et y se trouvent dans le plan Q qui contient les deux axes de symétrie (amont et aval) du guide principal A, c'est-à-dire dans le plan médian du guide principal A. L'axe x est perpendiculaire au miroir 6 et dirigé vers l'extérieur du guide principal A, et l'axe ,y, dans le même plan médian Q du coude, est à 90° de l'axe x, dans le sens contraire au sens de rotation des aiguilles d'une montre, et suivant les conventions d'usage habituel, l'axe z sort du papier perpendiculaire aux axes x et y. Pour simplifier l'explication qui suit, on définit aussi deux axes $Z_1$ et $Z_2$ suivant les deux axes de symétrie (amont et aval respectivement) du guide principal A. L'axe $Z_1$ est orienté dans la direction de propagation de l'énergie incidente $P_1$, selon l'axe du guide principal en amont, vers le miroir 6, et l'axe $Z_2$ est orienté dans la direction de propagation de l'énergie réfléchie $P_2$, selon l'axe du guide principal en aval, vers le miroir 6.

On s'intéresse, pour les besoins d'un exposé pédagogique, à la propagation en mode $HE_{11}$ des ondes approximativement planes dans ce système, un exemple instructif et réaliste pour des guides circulaires corrugués ou à revêtement intérieur diélectrique.

L'onde incidente sur le miroir avec puissance $P_1$ aura un champ magnétique $H_1$ qui varie approximativement comme :

$$H_1 = H_0 \exp(jwt) \exp(-jz_1 w/c)$$

$$= H_0 \exp(jwt) \exp(-j(x-y)2^{-\frac{1}{2}} w/c)$$

où : $H_0$ est une fonction d'amplitude réelle et lentement variable.dans l'espace, et

$J = (-1)^{+\frac{1}{2}}$

$w = 2.pi.f$ où $f$ = la fréquence de la radiation, et

$pi = 3.14159...$

$c$ = la vitesse de la lumière,

$t$ = temps,

et x, y et $z_1$ sont les coordonnées définies précédemment.

Le champ magnétique H peut avoir une polarisation arbitraire, qui peut être considérée comme une superposition linéaire de deux polarisations orthogonales, dont l'une a un champ magnétique perpendiculaire au plan de la figure suivant l'axe z, et dont l'autre a un champ magnétique dans le plan de la figure (suivant l'axe y comme on le démontrera plus loin).

Dans le cas où le champ magnétique suit l'axe z, le champ magnétique dû à l'onde réfléchie par le miroir a l'expression :

$$H_2 = H_0 \exp(jwt) \exp(j(x + y)2^{-\frac{1}{2}} w/c),$$

et le champ total $H_m$ à la surface du miroir ($x = 0$):

$$H_m = H_1 + H_2 = 2H_0 \exp(jwt) \exp(-j(y)2^{-\frac{1}{2}} w/c),$$

et pour obtenir une phase constante sur la surface du miroir, cette dernière équation nous montre qu'il faut que $t + 2^{-\frac{1}{2}} y/c$ soit constant, ce qui indique une onde qui progresse à la surface du miroir dans la direction -y à la vitesse $2^{\frac{1}{2}}c$.

Par une démonstration similaire pour une onde $P_2$ réfléchie par la charge d'utilisation vers le miroir dans le sens $z_2$, on voit facilement que cette onde sera réfléchie par le miroir dans le sens $-z_1$, et semblera se propager à la surface du miroir dans la direction +y à la vitesse $2^{\frac{1}{2}}c$.

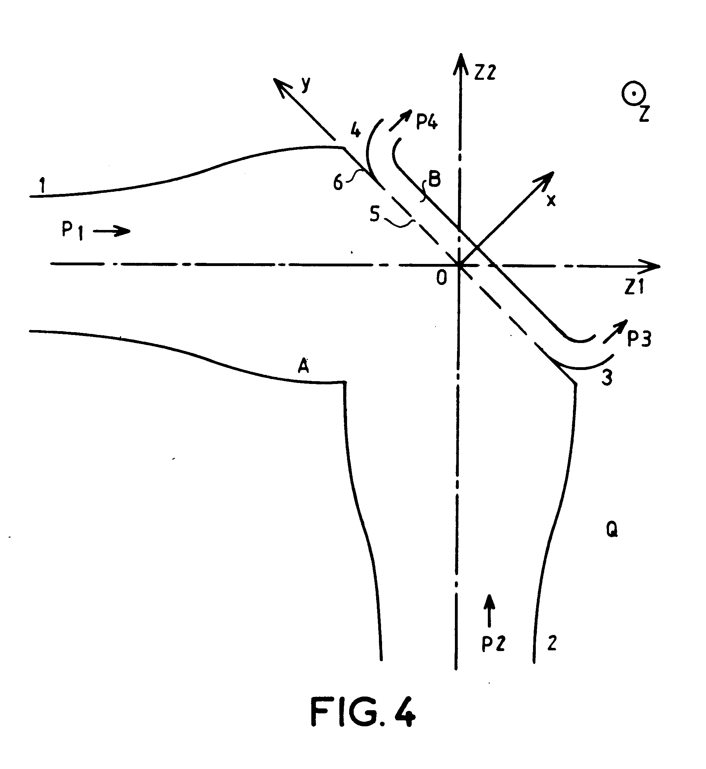

Ainsi, on voit que la vitesse de propagation de l'onde incidente dans le sens $z_1$, diffère de la vitesse de l'onde réfléchie dans le sens $z_2$, sur la surface du miroir, par le signe : le premier selon -y et le deuxième selon +y. Cette propriété permet la construction d'un coupleur directionnel à la surface du miroir par l'adjonction d'un guide secondaire orienté parallèlement à l'axe y, couplé par des trous comme on le verra plus loin (figure 4).

Dans le cas où le champ magnétique est dans le plan de la figure, par contre, l'onde incidente aura deux composants orthogonaux suivant les axes x et y :

$$H_{x1} = 2^{-\frac{1}{2}}H_0 \exp(jwt) \exp(-jz_1 w/c)$$

$$= 2^{-\frac{1}{2}}H_0 \exp(jwt) \exp(-j(x-y)2^{-\frac{1}{2}} w/c), \text{ et}$$

$$H_{y1} = 2^{-\frac{1}{2}}H_0 \exp(jwt) \exp(-jz_1 w/c)$$

$$= 2^{-\frac{1}{2}}H_0 \exp(jwt) \exp(-j(x-y)2^{-\frac{1}{2}} w/c),$$

avec des formes similaires pour l'onde réfléchie. A la surface du miroir (x=0), la composante y, parallèle au plan du miroir, est réfléchie sans inversion de signe : $H_{y1}(x=0) = H_{y2}(x=0)$ ; et la composante x, perpendiculaire au plan du miroir, est réfléchie avec inversion de signe : $H_{x1}(x=0) = -H_{x2}(x=0)$. Cette condition à la surface du miroir détermine les champs dans tout l'espace, c'est-à-dire que l'onde réfléchie, pour tout x, a la forme :

$$H_{x2} = -2^{-\frac{1}{2}}H_0 \exp(jwt) \exp(j(x+y)2^{-\frac{1}{2}} w/c), \text{ et}$$
$$H_{y2} = +2^{-\frac{1}{2}}H_0 \exp(jwt) \exp(j(x+y)2^{-\frac{1}{2}} w/c),$$

Pour x = 0, à la surface du miroir, $H_x = H_{x1} + H_{x2} = 0$, et $H_y = H_{y1} + H_{y2}$

$$H_y = 2^{-\frac{1}{2}}H_0 \exp(jwt) (\exp(j(x+y)2^{-\frac{1}{2}} w/c) + \exp(-j(x-y)2^{-\frac{1}{2}}w/c),$$
$$H_y = 2^{+\frac{1}{2}}H_0 \exp(jwt) \exp(jy 2^{-\frac{1}{2}} w/c) \cos(2^{-\frac{1}{2}} wx/c),$$

ce qui indique une onde qui progresse à la surface du miroir dans la direction -y à la vitesse $2^{\frac{1}{2}}c$, mais avec le champ magnétique dirigé suivant l'axe y. Nous notons aussi que l'amplitude des champs résultant dans le cas des champs dans le plan de la figure est différent du ras où les champs sont parallèles à l'axe z avec un rapport de $2^{+\frac{1}{2}}$.

La figure 3 montre schématiquement et en coupe un exemple plus réaliste de coude à miroir connu de l'art antérieur pour une ligne de transmission hyperfréquence, utilisant le même système de coordonnées cartésiennes que la figure 2. Sur cette figure 3, on voit que la section du guide principal varie selon sa longueur, pour la raison suivante.

Dans notre discussion la figure 2, nous avons utilisé l'approximation des ondes planes arrivant à la surface du miroir, et nous avons négligé les effets de diffraction des ondes à leur sortie d'une section de guide droit. Cette diffraction introduit une distorsion du front de l'onde, et l'approximation que nous avons fait ne reflète pas la réalité avec une assez grande précision. La forme particulière du guide montré sur la figure 3 permet de corriger la distorsion due à la diffraction au voisinage du coude, avec le résultat que les ondes arrivant à la surface du miroir sont suffisamment planes pour que les calculs exposés ci- dessus soient assez exacts

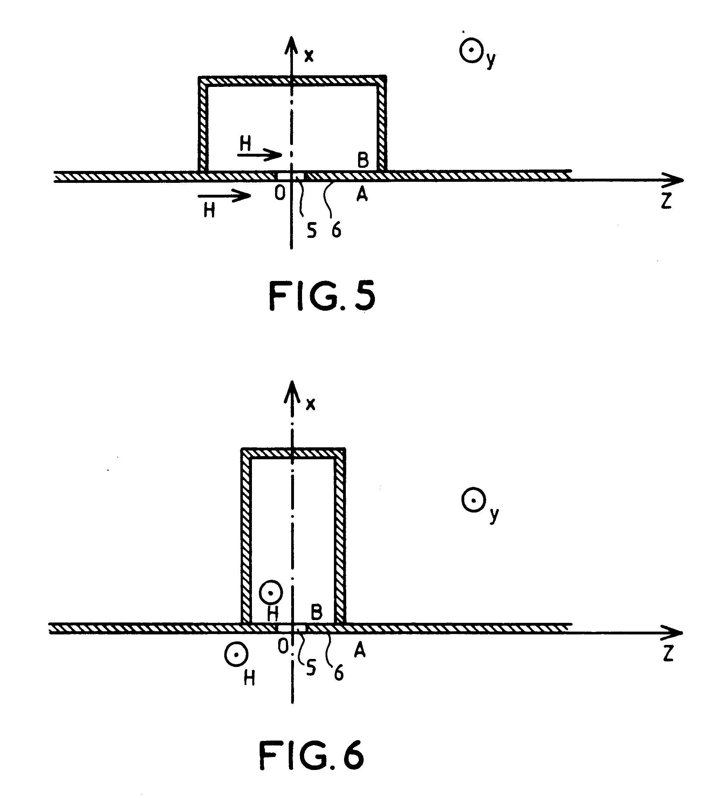

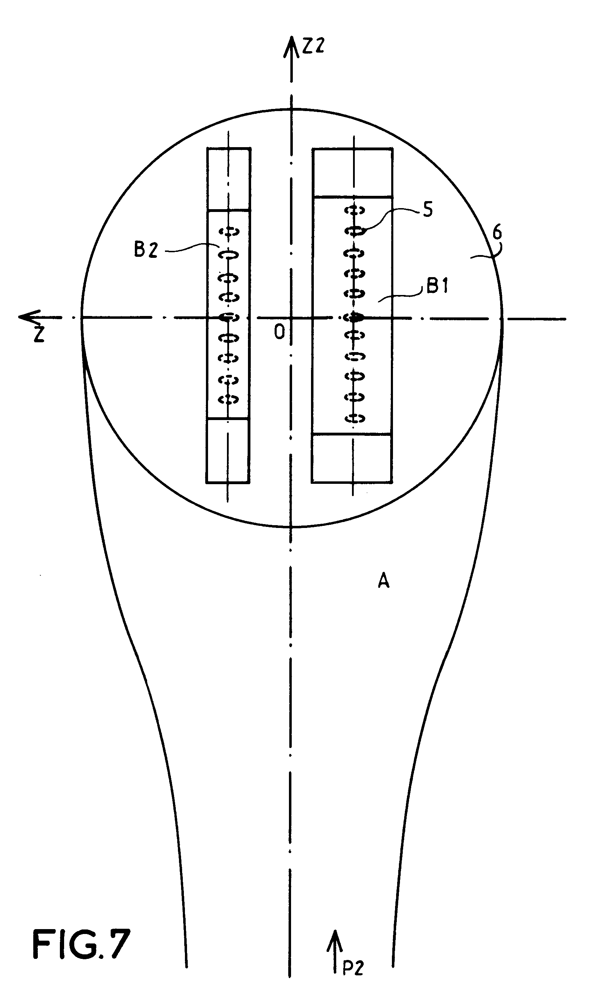

La figure 4 montre schématiquement et en coupe un exemple de dispositif selon l'invention, de coupleur directionnel couplé à un coude à miroir par des trous de couplage 5. Le coude à miroir est similaire aux coudes connus de l'art antérieur montrés sur les figures 2 et 3, et nous avons retenu le même système de coordonnées cartésiennes pour le décrire. Comme précédemment, la puissance $P_1$ est incidente selon l'axe $z_1$, et ensuite réfléchie à 90° par le miroir 6 dans la direction de l'axe $z_2$. Ces axes de propagation $z_1$ et $z_2$ sont dans le même plan Q que les axes x et y utilisés dans les calculs de champs ci-dessus. Le plan Q coupe le dispositif de la figure 6 en deux parties symétriques, mais dans d'autres exemples de réalisations selon l'invention, ceci n'est pas forcément le cas (voir figure 7, par exemple).

L'exemple de réalisation selon l'invention montré sur la figure 4 est réalisé en fixant un guide secondaire rectangulaire B sur le miroir 6, à l'extérieur du coude (x > 0), de telle manière à ce qu'une paroi du guide secondaire rectangulaire B soit accolé sur une partie de sa longueur sur l'extérieur du miroir 6, et des trous de couplage 5 permettront le couplage de l'énergie circulant à l'intérieur du guide principal A avec l'intérieur du guide secondaire B comme dans un coupleur classique. Cependant, comme nous avons vu quand nous avons calculé les champs dans notre discussion de la figure 2 : l'orientation des champs, donc l'orientation relative des guides et les modes de propagation de l'énergie circulant dans le guide principal ont une influence sur le couplage qui peut être obtenu. Cet effet peut être exploité à notre avantage comme on l'expliquera plus loin (figures 5 et 6).

Le guide secondaire rectangulaire B aura quatre parois dont deux relativement plus larges, et deux relativement moins larges. Une seule paroi sera accolée au miroir 6 et percée avec les trous de couplage 5. Par un choix astucieux des largeurs de ces parois, et de la paroi qui sera accolée au miroir 6 et percée avec les trous de couplage 5, le guide peut être dimensionné pour fonctionner dans un mode fondamental, à la fréquence de fonctionnement du guide principal, avec une vitesse de phase égale ou voisine de $C(2)^{\frac{1}{2}}$.

La figure 5 montre schématiquement et en coupe suivant un plan contenant les axes x et z définis précédemment, un détail d'un dispositif selon l'invention. On y voit une portion du miroir 6 avec un trou de couplage 5 permettant le couplage de l'intérieur du guide principal A avec l'intérieur du guide secondaire B. Suivant la première hypothèse examinée dans les calculs faits dans notre discussion de la figure 2, le champ magnétique H est orienté selon l'axe z, la paroi relativement plus large du guide secondaire B est accolée sur le miroir, et le guide secondaire B est excité dans le mode $TE_{01}$.

La figure 6 montre schématiquement et en coupe suivant un plan contenant les axes x et z définis précédemment, un détail d'un autre dispositif selon l'invention. On y voit une portion du miroir 6 avec un trou de couplage 5 permettant le couplage de l'intérieur du guide principal A avec l'intérieur du guide secondaire B. Suivant la deuxième hypothèse examinée dans les calculs faits dans notre discussion de la figure 2, le champ magnétique H est orienté selon l'axe y, la paroi relativement moins large du guide secondaire B est accolée sur le miroir, et le guide secondaire B est excité dans le mode $TE_{10}$.

La figure 7 montre schématiquement et en plan un autre exemple de réalisation selon l'invention, d'un coupleur directionnel avec deux guides secondaire $B_1$ et $B_2$, orientés respectivement avec la paroi relativement plus large accolée sur le miroir 6 ($B_1$), et avec la paroi relativement moins large accolée sur le miroir 6 ($B_2$). Nous avons donc une combinaison des deux réalisations montrées sur les figures 5 et 6, avec le guide $B_1$ fonctionnant en mode $TE_{01}$, et le guide $B_2$ fonctionnant en mode $TE_{10}$. Le guide $B_1$ est sensible à la polarisation parallèle à l'axe z du champ magnétique H dans le guide principal A, et le guide $B_2$ est sensible à la polarisation (orthogonale à cette dernière) parallèle à l'axe y du champ magnétique H dans le guide principal A. Ce dispositif permet ainsi de mesurer simultanément la puissance incidente $P_1$ et la puissance réfléchie $P_2$ dans les deux polarisations.

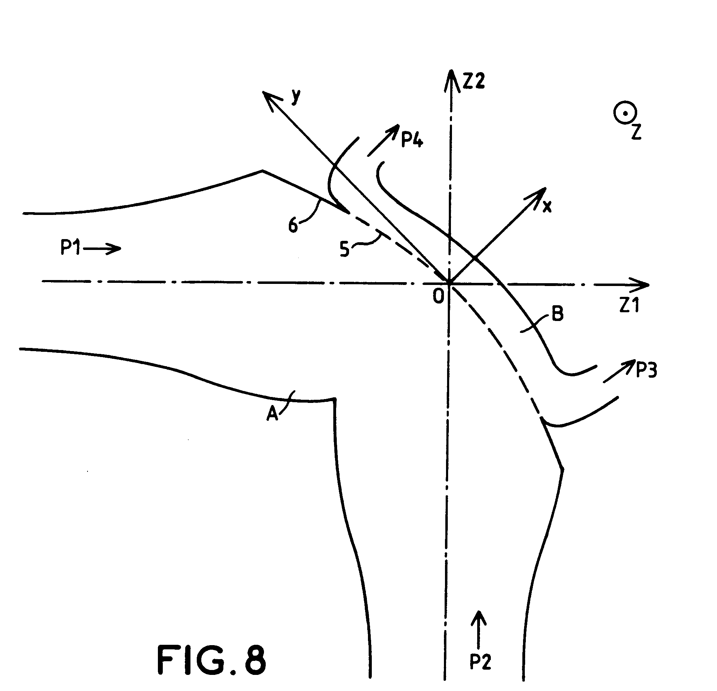

Sur les figures 4 à 7 on a supposé que le miroir 6 était plan. On peut envisager qu'il soit courbe. Il peut par exemple avoir des génératrices elliptiques dans deux directions perpendiculaires. Cette configuration est représentée sur la figure 8. Les deux directions sont y et z. Dans cette configuration, le guide d'ondes secondaire B est courbé pour épouser la courbure du miroir 6. Cette structure permet de supprimer la divergence qui apparait lors de l'incidence d'une onde sphérique avec un miroir plan.

## Revendications

**1** - Coupleur directionnel comportant un guide d'ondes principal (A) transportant une puissance hyperfréquence et au moins un guide d'ondes secondaire (B) accolé et couplé au guide d'ondes principal (A), caractérisé en ce que le guide d'ondes principal comporte une partie en forme de coude à miroir (6), le guide d'ondes secondaire (B) étant accolé au guide d'ondes principal (A) au niveau du miroir (6), le miroir (6) et le guide d'ondes secondaire (B) étant pourvu de trous (5) de couplage qui coïncident.

**2** - Coupleur directionnel selon la revendication 1, caractérisé en ce que le guide d'ondes secondaire (B) comporte deux petits côtés opposés et deux grands côtés opposés.

**3** - Coupleur directionnel selon la revendication 2, caractérisé en ce qu'un grand côté du guide d'ondes secondaire (B) est accolé au miroir (6), le grand côté étant pourvu de trous de couplage (5), un mode de propagation transverse magnétique existant dans le guide d'ondes secondaire (B).

**4** - Coupleur directionnel selon la revendication 2, caractérisé en ce qu'un petit côté du guide d'ondes secondaire (B) est accolé au miroir, ce petit côté étant pourvu de trous de couplage, un mode de propagation transverse électrique existant dans le guide d'ondes secondaire (B).

**5** - Coupleur directionnel selon l'une des revendications 2 à 4, caractérisé en ce que, lorsque deux guides d'ondes secondaires sont accolés au miroir (6) l'un des guides d'ondes secondaires est accolé au miroir (6) par un petit côté et l'autre par un grand côté.

**6 -** Coupleur directionnel selon l'une des revendications 1 à 5, caractérisé en ce que le miroir est plan.

**7 -** Coupleur directionnel selon l'une des revendications 1 à 5, caractérisé en ce que le miroir présente une courbure.

**8 -** Coupleur directionnel selon la revendication 7, caractérisé en ce que le guide d'ondes secondaire (B) est courbé pour épouser la courbure du miroir.

FIG.1

P1, P2, P3, P4, A, B, L, 1, 2, 3, 4, 5

# FIG. 2

FIG. 3

FIG. 4

FIG. 5

FIG. 6

FIG.7

FIG.8

Office européen
des brevets

## RAPPORT DE RECHERCHE EUROPEENNE

Numero de la demande

EP    92 40 1038
Page 1

| DOCUMENTS CONSIDERES COMME PERTINENTS | | | |
|---|---|---|---|
| Catégorie | Citation du document avec indication, en cas de besoin, des parties pertinentes | Revendication concernée | CLASSEMENT DE LA DEMANDE (Int. Cl.5 ) |
| A | US-A-3 999 151 (BALDWIN ET AL.)<br>* colonne 4, ligne 3 - ligne 35; figure 3 *<br>--- | 1,4 | H01P5/18<br>G01R21/01 |
| A | FR-A-2 448 229 (SPINNER GMBH ELEKTROTECHNISCHE FABRIK)<br>* page 3, ligne 34 - page 4, ligne 36; figure 2 *<br>--- | 1 | |
| A | JAPANESE JOURNAL OF APPLIED PHYSICS.<br>vol. 13, no. 2, Février 1974, TOKYO JP<br>pages 296 - 305;<br>S.MIYAKE ET AL.: 'Experimental investigation of coaxial microwave plasmatron in nitrogen gas'<br>* page 297, colonne de gauche, ligne 1 - ligne 16; figure 1 *<br>--- | 1,6 | |
| A | IEEE TRANSACTIONS ON NUCLEAR SCIENCE.<br>vol. 32, no. 5, Octobre 1985, NEW YORK US<br>pages 2921 - 2923;<br>L.M.EARLEY ET AL.: 'New directional couplers for multimode circular waveguides applied to intense pulsed microwave systems'<br>* page 2921, colonne de droite, ligne 31 - page 2922, colonne de gauche, ligne 14; figures 1,4,5 *<br>--- | 1,4 | |
| A | NTIS TECH NOTES.<br>Octobre 1988, SPRINGFIELD, VA US<br>page 863;<br>D.J.HOPPE ET AL.: 'Microwave transmitter with multimode output section'<br>* le document en entier *<br>--- | 5 | DOMAINES TECHNIQUES RECHERCHES (Int. Cl.5 )<br><br>H01P<br>G01R<br>H05B<br>H05H |
| A | US-A-4 025 878 (PREDMORE)<br>* colonne 6, ligne 1 - ligne 31; figure 3 *<br>--- | 7,8 | |
| A | US-A-3 090 931 (MARCATILI)<br>* colonne 2, ligne 67 - colonne 3, ligne 47; figure 1 *<br>--- | 7 | |

Le présent rapport a été établi pour toutes les revendications

| Lieu de la recherche | Date d'achèvement de la recherche | Examinateur |
|---|---|---|
| LA HAYE | 30 JUIN 1992 | DEN OTTER A.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

**Office européen des brevets**

# RAPPORT DE RECHERCHE EUROPEENNE

Numero de la demande

EP    92 40 1038
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| P,A<br><br>A | PATENT ABSTRACTS OF JAPAN<br>vol. 15, no. 258 (E1084) 28 juin 1991<br>& JP-A-3 083 401 (MATSUSHITA ELECTRIC WORKS LTD) 9 avril 1991<br><br>----- | 1 | |

**DOMAINES TECHNIQUES RECHERCHES (Int. Cl.5)**

Le présent rapport a été établi pour toutes les revendications

| Lieu de la recherche | Date d'achèvement de la recherche | Examinateur |
|---|---|---|
| LA HAYE | 30 JUIN 1992 | DEN OTTER A.M. |